# EUROPEAN PATENT SPECIFICATION

(11) **EP 2 019 323 B1**
(45) Date of publication and mention of the grant of the patent: **27.05.2015**
(21) Application number: 07018994.9
(22) Date of filing: 27.09.2007
(51) Int. Cl.: G01R 29/16, G01R 31/02, G01R 15/16

(54) **Device and method for indicating and signalling changes in a three-phase voltage system of power line, with the purpose to detect interrupted conductions**
Vorrichtung und Verfahren zum Anzeigen und Signalisieren von Änderungen in einem Drehspannungssystem einer Stromleitung mit dem Ziel, unterbrochene Zustände zu erkennen
Dispositif et procédé pour indiquer et signaler les modifications dans un système de tension triphasé de ligne électrique, avec pour objectif de détecter les conductions électriques interrompues

(30) Priority: 27.07.2007 SI 200700190
(43) Date of publication of application: 28.01.2009
(73) Proprietor: KOLEKTOR SINABIT d.o.o., 1235 Radomlje (SI); C & G d.o.o. Ljubljana, 1000 Ljubljana (SI)
(72) Inventor: mag. Tor'os, Zvonko, 5112 Dobrova v Brdih (SI); mag. Bezjak, Marjan, 2000 Maribor (SI)
(74) Representative: Knoop, Philipp

(56) References cited:
- EP-A1- 0 567 904
- EP-A1- 1 603 211
- WO-A1-2004/111665
- WO-A1-2005/119277
- SI-A- 21 717
- US-A- 5 543 995
- US-A1- 2001 040 446
- US-B1- 6 459 998
- US-B1- 6 470 283
- SENGER E C ET AL: "BROKEN CONDUCTORS PROTECTION SYSTEM USING CARRIER COMMUNICATION", IEEE TRANSACTIONS ON POWER DELIVERY, IEEE SERVICE CENTER, NEW YORK, NY, US, vol. 15, no. 2, 1 April 2000 (2000-04-01), pages 525-530, XP011049849, ISSN: 0885-8977, DOI: 10.1109/61.852979
- WESTROM A C ET AL: "OPEN CONDUCTOR DETECTOR SYSTEM", IEEE TRANSACTIONS ON POWER DELIVERY, IEEE SERVICE CENTER, NEW YORK, NY, US, vol. 7, no. 3, 1 July 1992 (1992-07-01), pages 1643-1651, XP000292639, ISSN: 0885-8977, DOI: 10.1109/61.141885

## Description

The subject of the invention is a device and method for indicating and signalling changes in a three-phase voltage system of power line, with the purpose to detect interrupted conductors, or more precisely a device and method for indicating and remote signalling of the presence or non-presence of electrical phase voltage and symmetry or asymmetry of the system of the three-phase voltages in three-phase power lines.

According to the international patent classification this invention belongs to H 01 H 83/14 and, additionally, to G 08B 29/00.

The technical problem solved by this invention is such a construction of a device to enable, in accordance with the corresponding method, a simple and effective indication and remote signalling of voltage changes within the controlled three-phase power line system, resulting in quickly acquired and reliable information about the interruption of one, two or of all three conductors up to the location where the device will be located.
In addition to that, the construction of the device will be simple and compact, and it will be possible to build it into new and also into existing networks, preferentially into transformer stations and/or onto poles.

There are several known devices for detecting interrupted conductors in electrical networks. According to patent SI 21482 (EP 1603211) a known device used to detect and to disconnect an interrupted covered conductor in medium voltage power lines consists of an indicator unit at the end of power line with semi-insulated conductors and of a disconnection unit at the beginning of a power line. It functions in such a way that the indicator unit detects the interruption of a covered conductor and transmits the information about that to the disconnection unit, which, via a suitable switch, disconnects the voltage in this power line. Weakness and deficiency of this known solution is in the fact that it detects and signals only the presence or non-presence of phase voltage within a three-phase power line but it does not supply information concerning the number of interrupted conductors.

Another known solution is according to patent SI 21717. According to this document, detecting the location of an interrupted conductor within all conductor types is selective, by means of adequately located detectors and by means of measuring line voltage, inverse and in-phase voltage system components. Weakness of this known solution is that, in spite of a very demanding construction, it does not reveal the data about the number of interrupted conductors in this location. It is characteristic of both previously described known solutions that they make it possible to indicate interrupted conductors in the electrical network, but they do not reveal information about the number of interrupted conductors.

Furthermore, also a known solution is the construction of a voltage indicator according to IEC 61958 and IEC 61243-5 i, intended for detecting the presence of phase voltage in the observed power line. Weakness and deficiency is in the fact that it does not detect asymmetry of three-phase system voltage and also not the interruption of conductors.
Weakness and deficiency of all three described solutions represent a problem, which has remained unsolved.

WO 2004/111665 A1 discloses a method of monitoring an electrical three-face system. An input terminal is connected to the electrical system to receive the current and voltage input signals. An operator pre-defines threshold settings suitable for the power lines. A comparator reduces output signals which activate ancillary equipment controlling the supply to the power lines. A comparator produces output signals which activate ancillary equipment controlling the supply of power to the load. No indication is given which power line is interrupted.

US 6 459 998 B1 discloses a system for detection of open circuits along a power line. The system compares the nature of the voltage and of the current signals present on the power line at the time an open circuit condition is indicated. When a failure in the power system is detected, the power is removed from that effected line.

WO 2005/119277 A1 discloses a method of monitoring line faults in a medium voltage network. The control centre computer and a plurality of measurement sensors are located remote from an electricity generating plant on the medium voltage power lines. The disclosed method allows the determination of a likely cause of a fault as well as of the likely location of a fault. The disclosed system is very complex.

Senger E.C. et al. describe a detection and signalling system designed to identify and locate high impedance faults caused by broken conductors on distribution primary feeders; see IEEE transactions on power delivery IEEE service centre, New York, N.Y./US, vol. 15, no. 2., 1 April 2000, pages 525-530 in order to detect the voltage unbalance in the system produced by a broken conductor. A new sensor was developed which is sensitive to the electrical field generated by primary feeders.

A.C. Westrom et al. describe an open face conductor detector system; see IEEE transactions on power delivery IEEE service centre, New York, N.Y./US vol. 7, no. 3, 1. July 1992, pages 1643-1651. This system is usually implemented for single distribution lines. No hint for a pre-face system is given.

US 5 543 995 A discloses a method and an operator for preventing re-closing of circuit breakers to reconnect a transmission line when a break fault occurs in the transmission line. This system is suitable for a single power line; the equipment is very complex.

US 6 470 283 B1 discloses an electric power monitoring device that sensors power system voltages in a three-face system by capacitive coupling to one or more power system conductors. The voltage across the capacitor is proportional to the power system voltage and is used as an information signal which is analysed by a micro processor. The derived information may be displayed on a monitor.

According to the invention the before mentioned problems are resolved by a device and a method as described in the independent claims 1 and 8, respectively. Advantageous embodiments are described in the dependent claims.

Disclosed therein are a device and a method essentially consisting of an indicator unit and communication unit, which make it possible to detect not only phase voltage failure in conductors but also the type of asymmetry at a certain point of a three-phase voltage system in power line, and simultaneously also the formation and transmission of a message about the location of the power line interruption and also about that whether one, two or three conductors are interrupted in the power line. The invention will be described based on the preferential feasibility example and figures, which present as follows:
- Fig. 1: a schematic presentation of the device according to the invention
- Fig. 2: a block scheme of the indicator unit
- Fig. 3: a block scheme of the communication unit
- Fig. 4: graphical presentation of the normal condition, i.e. of the condition before the failure, for the connection Dyn5
- Fig. 5: graphical presentation of the condition after the failure, for the connection Dyn5
- Fig. 6: graphical presentation of the normal condition, of the condition before the failure, for the connection Yzn5
- Fig. 7: graphical presentation of the condition after the failure, for the connection Yzn5

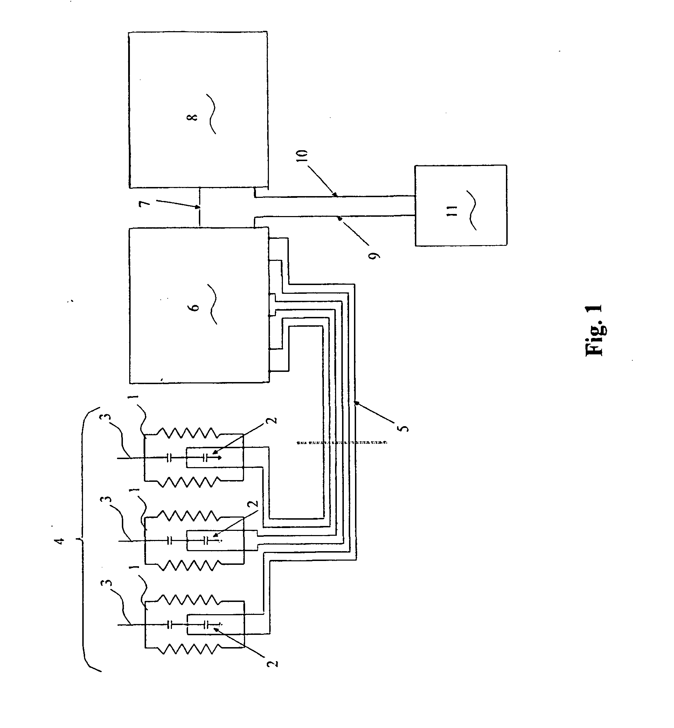

Fig. 1 shows that the device for indicating and signalling changes in the three-phase voltage system of power line, with the purpose to detect interrupted conductors according to the invention consists of an indicator unit 6 assembly, communication unit 8 assembly and battery 11, which functions as an auxiliary source of voltage supply. Thereby the device according to the invention is connected to the three-phase system 4 of the corresponding power line by means of cable connection 5. Within one power line, one or several devices according to the invention can be mounted at optional locations.

The three-phase system 4 of power line essentially consists of three conductors 3, each of them having at least one insulator 1, with built-in corresponding capacitive voltage divider 2. To capacitive voltage dividers 2, an indicator unit 6 of the device according to the invention is connected by means of a suitable cable connection 5. The cable connection 5 is preferentially constructed, using insulated and armoured conductors.

Further, the indicator unit 6 is joined with the communication unit 8 by means of the connection 7, in addition to that, it is connected to a battery 11, by means of an insulated cable 9. The connection 7 is of optional construction, it can be carried out via cable or via infrared rays (IR) or a light signal, it can also be digital with relays and via RS and Ethernet communication and similar. In the feasibility example of the invention, for the connection 7, an Ethernet and RS232/RS485 construction is used.

The communication unit 8 is also connected to the battery 11, by means of an insulated cable 10.

Therefore, both, the indicator unit 6, by means of insulated cable 9, and the communication unit 8, by means of insulated cable 10, are connected to the battery 11. As previously described, the battery 11 represents an auxiliary source of voltage, supplying voltage to the device according to the invention respectively its indicator unit 6 and its communication unit 8 if it comes to voltage U failure within the observed power line respectively its three-phase system 4.

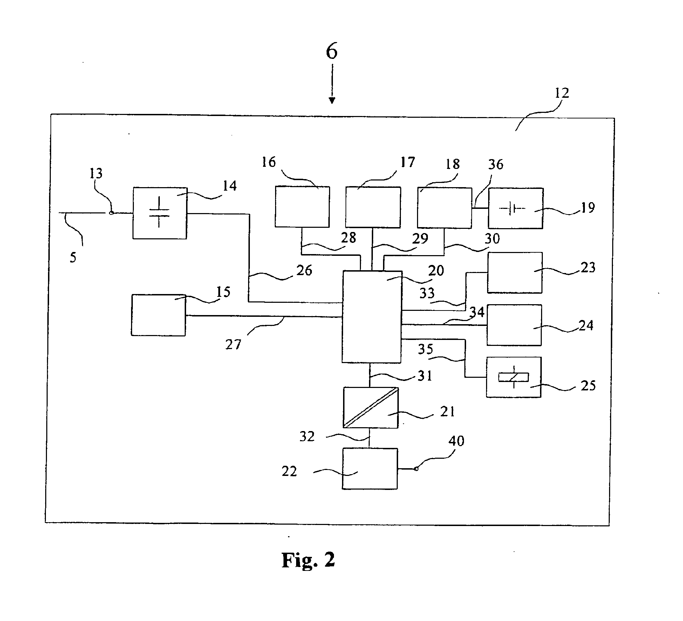

Fig. 2 shows the assembly of the indicator unit 6; its voltage divider 14 is, on the input side, by means of a clamp 13 and cable connection 5, connected to the corresponding conductors 3 of the three-phase system 4, whereas on the output side, it is connected with the communications module 22 and via clamp 40 to the communications module 38 in the communication unit 8.

Within the housing 12 of the indicator unit 6, the voltage divider 14 and the memory card 15 are connected to the microprocessor 20, the first one with the connection 26 and the latter one with the connection 27. The Data Flash 16, with the connection 28, EEPROM 17, with the connection 29, and clock 18 with the integrated time relay and battery 19, with the connection 30 and 36, are also connected to the microprocessor 20. In addition to that, the keyboard 23, with the connection 33, further the LCD display 24, with the connection 34, and the relay exit 25, with the connection 35, are also connected to the microprocessor 20.
A connection 31 comes from the microprocessor 20, connecting it to the galvanic disconnection 21, with a built-in optocoupler. The communications module 22 is, with the connection 32, connected to the galvanic disconnection 21, the communications module 22 is, as previously described, by means of a clamp 40, connected to the communications module 38, which is located in the communication unit 8.
The voltage divider 14 of the indicator unit 6 functions as a converter of the signal of phase voltages U_{f}, with input impedance X_{c} in the range between 36 and 43,2 MΩ and capacitance Cₛ in the range between 74 and 88 pF, at the frequency of f = 50Hz.
The microprocessor 20 of the indicator unit 6 is used for measuring and calculating phase voltages U_{f} and line voltages U, and for measuring angles α between fundamental harmonic functions of phase voltages U_{f}.

According to above-described, it is evident that the indicator unit 6 has at least four alarm entrances/exits and an RS connection 7, with the designation RS 232/485, a MMC respectively insertable memory card 15 for data transfer as well as for settings and upgrades, in addition to that also a clock 18 with a time relay to set delay alarms, further a graphic display respectively an LCD display 24 and corresponding plug sockets to display the presence of voltage by means of a plug indicator if the indicator unit 6 does not display the presence of voltage. The mentioned plug sockets and plug indicator are not presented in Figures, as they are defined based on IEC 16958 and IEC 61243-5.

As previously described, it is evident that the indicator unit 6 measures effective values of phase voltages U_{f}, and effective values of line voltages U as well as angles α between fundamental harmonic functions of phase voltages. Based on measured four alarm values, the communication unit 8 generates a message, the contents of which correspond to the combination of activated alarms. The message is then sent respectively submitted to a control centre and/or to some other address.

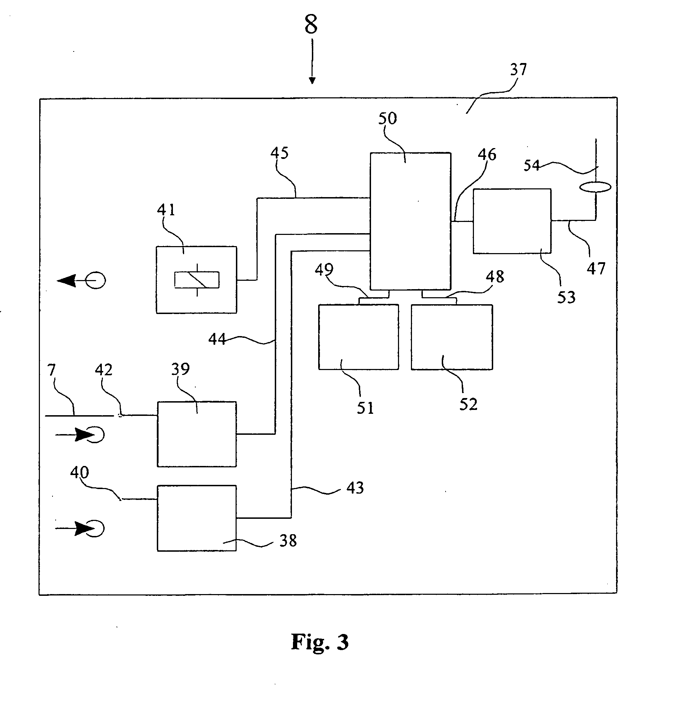

Fig. 3 shows the communication unit 8 assembly. Within the housing 37, there are located the above-mentioned communications module 38, which is, by means of a clamp 40, connected to the communications module 22 of the indicator unit 6, and a digital entrance 39, which is, by means of a clamp 42 and connection 7, also connected to the indicator unit 6. The communications module 38 and digital entrance 39 are located within the housing 37, they are connected to the microprocessor 50, the first one by means of the connection 43, and the second one by means of the connection 44. To the microprocessor 50, there are also connected: relay exit 41 by means of the connection 45, communications modem 53 by means of the connection 46, real-time clock 51 by means of the connection 49, and Data Flash 52 by means of the connection 48. An antenna 54 is connected to the communications modem 53 by means of the connection 47.
In relation to this, a mobile phone, a VHF station or similar can be used as the communications modem 53 of the communication unit 8. The real-time clock 51 is actually a clock mechanism used for performing this function. For the device according to the invention it holds that capacitive voltage dividers 2, in insulators 1, change high phase voltages U_{f}, higher than 1 kV, to low phase voltages U_{f}, lower than 1 kV, and transmit these changes to the indicator unit 6 via the cable connection 5. Thereby the indicator unit 6, on a permanent basis, measures effective values of phase voltages U_{f} in individual conductors 3, on the basis of which it detects their presence or absence as well as symmetry and asymmetry. In addition to that, the indicator unit 6 detects and indicates also changes in these phase voltages U_{f} and line voltages U, and communicates them, primarily the ones with alarm values, to the communication unit 8, via the connection 7. In the communication unit 8, these phase voltages U_{f} and line voltages U that alarmingly differ from effective values are analysed and the type of error, which is the reason for these deviations, is established; in addition to that, the number of conductors 3 within the three-phase system 4 that are interrupted and their location are established; the data acquired in this way is then sent to the control centre by means of a wire or wireless connection, e.g. via VHF, SMS, GPRS and/or data message, etc.

When the three-phase system 4 of the electrical network is smaller than 1 kV, it is characteristic that insulators 1 with capacitive voltage dividers 2 are not necessary in the three-phase system 4.

As previously mentioned, the indicator unit 6 performs, on a permanent basis, measurements of effective phase voltages U_{f}, effective line voltages U, as well as of angles α between fundamental harmonic functions of phase voltages U_{f}, all of these in conductors 3 and among them, within the observed three-phase system 4, in the corresponding power line. The task of the communication unit 8 is to, after a certain number of successively measured alarm values, communicated to it by the indicator unit 6, generate a message that corresponds to the combination of activated alarms and then submit it to the receiving control centre to be processed. In our case, the message is generated by the communication unit 8 after four measurements have been carried out.

As a rule, the device according to the invention respectively its indicator unit 6 functions based on an algorithm method.
The algorithm of indicator unit 6 functioning is based on indicating changes in nominal effective values of phase voltages U_{fN} and nominal effective value of line voltage U_{N} as well as in the values of angles α between individual fundamental harmonic functions of phase voltages U_{fN} in the three-phase system 4; in addition to that it is based on the algorithm of the information of the communication unit 8, which includes the message about the number of interrupted conductors 3, which is presented in the following Table 1:

**Table 1**

| Indicator unit 6 | | | | Communication unit 8 |
|---|---|---|---|---|
| one | all | all | one | Condition in the three-phase system 4 |
| U < 0,7·U_{N} | U < 0,7·U_{N} | U_{f} <0,4·U_{fN} | angle= - α | |
| NO | NO | NO | NO | Status O.K., no conductor 3 interrupted |
| NO | NO | NO | YES | One conductor 3 interrupted |
| YES | NO | NO | - | One conductor 3 interrupted |
| YES | YES | NO | - | Two conductors 3 interrupted |
| YES | YES | YES | - | Three conductors 3 interrupted |

It is evident from the Table 1 that when the indicator unit 6 detects that all effective line voltages are U > 0,7.U_{N} and that all U_{f} > 0,4·U_{fN} and that at least one angle α between fundamental harmonic functions of the phase voltage U_{f}, is negative, the communication unit 8, with a certain delay, informs the control centre and/or some other address that one conductor 3, out of three, in the three-phase system 4 is interrupted. Similarly, this applies also for other examples from the Table 1.

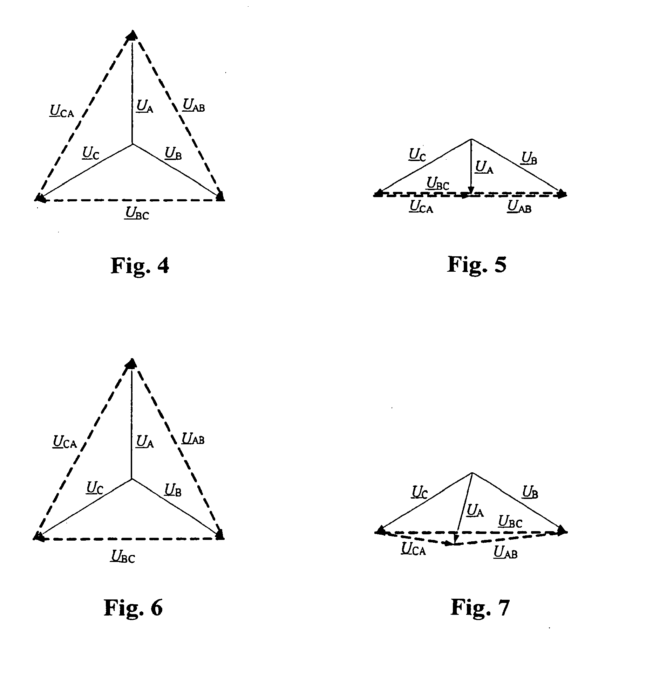

For the same example of failure of one out of three conductors 3, which is, as an example from Table 1, described in the previous paragraphs, a graphical presentation is given as well; the example is the result of empirical measurements.
Thus, a graphical presentation of the normal condition before the failure for the connection Dyn5 is shown in Fig. 4, whereas the condition after the failure for the same connection is presented in Fig. 5. For the connection Yzn5, the normal condition before the failure is graphically presented in Fig. 6, and the condition after the failure in Fig. 7.

In relation to the example with the connection Dyn5, the normal condition, i.e. the condition before interruption of one of the three conductors 3 in the three-phase system 4, is presented in Fig. 4, whereas the condition after the failure, i.e. the condition after the occurrence of the interruption of one of the three conductors 3, is shown in Table 2 and in Fig. 5. On the basis of the presentation before the failure, it is evident from Fig. 4 that the sizes of all the voltages U_{A}, U_{B}, U_{c}, U_{AB}, U_{BC} and U_{CA} are approximately the same, they are moved, in view of each other, by 120°. On the other hand, the presentation of the condition after the failure shows in Fig. 5 that, after the occurrence of the interruption of one of the three conductors 3, the sizes of voltages are no longer equal and two angles α between phase voltages U_{f} are negative, as it is presented in Table 3.

**Table 2**

| Ratios of primary voltages | | | |
|---|---|---|---|
| | A | B | C |
| Phase | 0.51 | 1.00 | 1.00 |
| voltages | 25 | 04 | 25 |
| | AB | BC | CA |
| Line | 0.49 | 0.99 | 0.49 |
| voltages | 97 | 92 | 82 |

**Table 3**

| Angles between primary voltages | | | |
|---|---|---|---|
| | AB | BC | CA |
| Phase | -57,06 | 119,88 | -60,3 |
| Line | 178,4 | 177,48 | 4,32 |

For the connection Yzn5, graphically presented in Fig. 6 and Fig. 7, and in Tables 4 and 5, the same remarks and description as given for the connection Dyn5 can be stated.

**Table 4**

| Ratios of primary voltages | | | |
|---|---|---|---|
| | A | B | C |
| Phase | 0.623 | 1.001 | 1.002 |
| | 1 | 0 | 5 |
| | AB | BC | CA |
| Line | 0.586 | 1.000 | 0.419 |
| | 5 | 8 | 2 |

**Table 5**

| Angles between primary voltages | | | |
|---|---|---|---|
| | AB | BC | CA |
| Phase | -76 | 120 | -45 |
| Line | 178,2 | 176 | -12,8 |

## Claims

1. A device for indicating and signalling changes in a three-phase voltage system of a power line, with the purpose to detect interrupted conductors, the device comprising:
a capacitive voltage divider (2) connected to each power line (3);
an indicator unit (6) connected with said capacitive voltage dividers (2), the indicator unit (6) being configured:
- to receive signals from said capacitive voltage dividers (2),
- to perform, on a permanent basis, measurements of the effective values of phase voltages (U_{f}), of the effective values of line voltages (U) and of the angles (α) between fundamental harmonic functions of phase voltages (U_{f}) and
- to detect and indicate changes between said measurements and respective nominal values (U_{fN}, U_{N}, α) stored in a memory card (15) and a data flash (16); and
a communication unit (8) connected via a galvanic disconnection (21) to said indicator unit (6) and being configured for sending information about interruption of conductors (3) to a control centre;
said indicator unit (6) and said communication unit (8) containing microprocessors (20, 50) configured to evaluate the measured data, as well as clocks (18, 51) and relays (25) configured to activate an alarm if the measured values differ from the nominal values for a certain time.

2. The device according to claim 1 **characterised in that** for each power line (3) one indicator unit (6) and one communication unit (8) is connected.

3. The device according to claim 1 or 2, **characterised in that** at least one communication unit (8) belongs to each indicator unit (6).

4. The device according to claim 1, **characterised in that** an individual conductor (3) has at least one or more voltage dividers (2).

5. The device according to claim 1, **characterised in that** the connection (7) between the indicator unit (6) and the communication unit (8) is a connection by cables, digitally communication units, via infrared rays or via light signals.

6. A method for indicating and signalling changes in a three-phase voltage system of a power line, with the purpose to detect interrupted conductors, the method comprising:
providing a capacitive voltage divider (2) connected to each power line (3);
receiving signals from said capacitive voltage dividers (2) ;
performing measurements of the effective values of phase voltages (U_{f}), of the effective values of line voltages (U) and of the angles (α) between fundamental harmonic functions of phase voltages (U_{f});
detecting and indicating changes between said measurements and respective nominal values (U_{fN}, U_{N}, α) ; and
activating an alarm indicative of a failure if the measured values differ from the nominal values for a certain time.

7. The method according to claim 6, **characterised in that** the sizes of line voltages are established.

8. The method according to claim 7, **characterised in that** a conductor (3) is interrupted if at least one angle (α) between the harmonics of the phase voltages (U_{f}) of the corresponding power lines is negative.

9. Method according to claim 7, **characterised in that** a conductor (3) is interrupted if at least one of the line voltages (U) is lower than 0.7 of the nominal effective value of the line voltage (U_{N}).

10. The method according to claim 7, **characterised in that** two conductors (3) are interrupted if all line voltages (U) are lower than 0.7 of the nominal effective value of the line voltage (U_{N}) and if at least one phase voltage (U_{f}) is present.

11. The method according to claim 7, **characterised in that** all three conductors (3) are interrupted if all line voltages (U) are lower than 0.7 of the nominal effective value of the line voltage (U_{N}) and if all effective values of the phase voltage are lower than 0.4 of the nominal effective value of the face voltage (U_{fN}).

## Patentansprüche

1. Vorrichtung zur Anzeige und Signalisierung von Änderungen in einem Drei-Phasen-Spannungssystem von einer Stromleitung, um unterbrochene Leiter zu detektieren, die Vorrichtung umfassend:
einen kapazitiven Spannungsteiler (2), der mit jeder Stromleitung (3) verbunden ist;
eine Anzeigeeinheit (6), die mit dem genannten kapazitiven Spannungsteiler verbunden ist, die Anzeigeeinheit ist konfiguriert:
- um Signale von dem genannten kapazitiven Spannungsteiler (2) zu erhalten,
- um auf einer permanenten Grundlage Messungen von den Effektivwerten von Phasenspannungen (U_{f}), von den Effektivwerten von Netzspannungen (U) und von den Winkeln (α) zwischen ersten harmonischen Funktionen von Phasenspannungen (U_{f}) durchzuführen und
- um Änderungen zwischen den genannten Messungen und entsprechenden Nennwerten (U_{F}, U_{N}, α), gespeichert auf einer Speicherkarte (15) und einem Daten-Flash, zu detektieren und anzuzeigen; und
eine Kommunikationseinheit (8), die über eine galvanische Unterbrechung (21) mit der genannten Anzeigeeinheit (6) verbunden ist, und zum Senden von Information über Unterbrechung von Leitern (3) an ein Kontrollzentrum konfiguriert ist;
wobei die genannte Anzeigeeinheit (6) und die genannte Kommunikationseinheit (8), Mikroprozessoren (20, 50), welche konfiguriert sind, um die gemessenen Daten auszuwerten, sowie Uhren (18, 51) und Relais (25), welche konfiguriert sind, um einen Alarm zu aktivieren, wenn die gemessenen Werte von den Nennwerten für eine bestimmte Zeit abweichen, enthalten.

2. Vorrichtung nach Anspruch 1, **dadurch gekennzeichnet, dass** für jede Stromleitung (3) eine Anzeigeeinheit (6) und eine Kommunikationseinheit (8) angeschlossen ist.

3. Vorrichtung nach Anspruch 1 oder 2, **dadurch gekennzeichnet, dass** wenigstens eine Kommunikationseinheit (8) zu jeder Anzeigeeinheit (6) gehört.

4. Vorrichtung nach Anspruch 1, **dadurch gekennzeichnet, dass** ein einzelner Leiter (3) wenigstens einen oder mehrere Spannungsteiler (2) hat.

5. Vorrichtung nach Anspruch 1, **dadurch gekennzeichnet, dass** die Verbindung (7) zwischen der Anzeigeeinheit (6) und der Kommunikationseinheit (8) eine Verbindung durch Kabel, digitale Kommunikationseinheiten, über Infrarotstrahlen oder über Lichtsignale ist.

6. Verfahren zur Anzeige und Signalisierung von Änderungen in einem Drei-Phasen-Spannungssystem von einer Stromleitung, um unterbrochene Leiter zu detektieren, wobei das Verfahren umfasst:
- Bereitstellung eines kapazitiven Spannungsteiler (2), der mit jeder Stromleitung (3) verbunden ist;
- Empfangen von Signalen von dem genannten kapazitiven Spannungsteiler (2);
Durchführung von Messungen von den Effektivwerten von Phasenspannungen (U_{f}), von den Effektivwerten von Netzspannungen (U) und von den Winkeln (α) zwischen ersten harmonischen Funktionen von Phasenspannungen (U_{f});
Detektion und Anzeige von Änderungen zwischen den genannten Messungen und entsprechenden Nennwerten (U_{fN}, U_{N}, α); und
Aktivierung eines auf einen Fehler hinweisenden Alarms, wenn die gemessenen Werte von den Nennwerten für eine bestimmte Zeit abweichen.

7. Verfahren nach Anspruch 6, **dadurch gekennzeichnet, dass** die Größen der Netzspannungen festgestellt werden.

8. Verfahren nach Anspruch 7, **dadurch gekennzeichnet, dass** ein Leiter (3) unterbrochen wird, wenn wenigstens ein Winkel (α) zwischen den Harmonischen von den Phasenspannungen (U_{f}) von den entsprechenden Stromleitungen negativ ist.

9. Verfahren nach Anspruch 7, **dadurch gekennzeichnet, dass** ein Leiter (3) unterbrochen wird, wenn wenigstens eine der Netzspannungen (U) niedriger als 0,7 des Nenneffektivwerts der Netzspannung (U_{N}) ist.

10. Verfahren nach Anspruch 7, **dadurch gekennzeichnet, dass** zwei Leiter (3) unterbrochen werden, wenn alle Netzspannungen (U) niedriger als 0,7 des Nenneffektivwerts der Netzspannung (U_{N}) sind und wenn wenigstens eine Phasenspannung (U_{f}) vorliegt.

11. Verfahren nach Anspruch 7, **dadurch gekennzeichnet, dass** alle drei Leiter (3) unterbrochen werden, wenn alle Netzspannungen (U) niedriger als 0,7 des Nenneffektivwerts von der Netzspannung (U_{N}) sind und wenn alle Effektivwerte der Phasenspannung niedriger als 0,4 des Nenneffektivwerts von der Phasenspannung (U_{fN}) sind.

## Revendications

1. Dispositif pour indiquer et signaler des changements dans un système de tension triphasé d'une ligne électrique, avec pour but de détecter des conducteurs interrompus, le dispositif comprenant :
un diviseur de tension capacitif (2) connecté à chaque ligne électrique (3) ;
une unité d'indication (6) connectée auxdits diviseurs de tension capacitifs (2),
l'unité d'indication (6) étant configurée pour :
- recevoir des signaux en provenance desdits diviseurs de tension capacitifs (2),
- effectuer, sur une base permanente, des mesures des valeurs efficaces de tensions de phase (U_{f}), des valeurs efficaces de tensions de ligne (U) et des angles (α) entre des fonctions d'harmoniques fondamentales de tensions de phase (U_{f}) et
- détecter et indiquer des changements entre lesdites mesures et des valeurs nominales respectives (U_{fN}, UN, α) stockées dans une carte de mémoire (15) et une mémoire flash de données (16) ; et
une unité de communication (8) connectée par l'intermédiaire d'une déconnexion galvanique (21) à ladite unité d'indication (6) et étant configurée pour transmettre des informations relatives à une interruption de conducteurs (3) à un centre de commande ;
ladite unité d'indication (6) et ladite unité de communication (8) contenant des microprocesseurs (20, 50) configurés pour évaluer les données mesurées, ainsi que des horloges (18, 51) et des relais (25) configurés pour activer une alarme si les valeurs mesurées diffèrent des valeurs nominales pendant un certain temps.

2. Dispositif selon la revendication 1, **caractérisé en ce que**, pour chaque ligne électrique (3), une unité d'indication (6) et une unité de communication (8) sont connectées.

3. Dispositif selon la revendication 1 ou 2, **caractérisé en ce qu'**au moins une unité de communication (8) appartient à chaque unité d'indication (6).

4. Dispositif selon la revendication 1, **caractérisé en ce qu'**un conducteur individuel (3) comporte au moins un ou plusieurs diviseurs de tension (2).

5. Dispositif selon la revendication 1, **caractérisé en ce que** la connexion (7) entre l'unité d'indication (6) et l'unité de communication (8) est une connexion par câbles, unités de communications numériques, par rayons infrarouges ou par signaux lumineux.

6. Procédé pour indiquer et signaler des changements dans un système de tension triphasé d'une ligne électrique, avec pour but de détecter des conducteurs interrompus, le procédé comprenant :
la disposition d'un diviseur de tension capacitif (2) connecté à chaque ligne électrique (3) ;
la réception de signaux en provenance desdits diviseurs de tension capacitifs (2) ;
l'exécution de mesures des valeurs efficaces de tensions de phase (U_{f}), des valeurs efficaces de tensions de ligne (U) et des angles (α) entre des fonctions d'harmoniques fondamentales de tensions de phase (U_{f}) ;
la détection et l'indication de changements entre lesdites mesures et des valeurs nominales respectives (U_{fN}, U_{N}, α) ; et
l'activation d'une alarme indicative d'une défaillance si les valeurs mesurées diffèrent des valeurs nominales pendant un certain temps.

7. Procédé selon la revendication 6, **caractérisé en ce que** les grandeurs de tensions de ligne sont établies.

8. Procédé selon la revendication 7, **caractérisé en ce qu'**un conducteur (3) est interrompu si au moins un angle (α) entre les harmoniques des tensions de phase (U_{f}) des lignes électriques correspondantes est négatif.

9. Procédé selon la revendication 7, **caractérisé en ce qu'**un conducteur (3) est interrompu si au moins une des tensions de ligne (U) est inférieure à 0,7 fois la valeur efficace nominale de la tension de ligne (U_{N}).

10. Procédé selon la revendication 7, **caractérisé en ce que** deux conducteurs (3) sont interrompus si toutes les tensions de ligne (U) sont inférieures à 0,7 fois la valeur efficace nominale de la tension de ligne (UN) et si au moins une tension de phase (U_{f}) est présente.

11. Procédé selon la revendication 7, **caractérisé en ce que** les trois conducteurs (3) sont interrompus si toutes les tensions de ligne (U) sont inférieures à 0,7 fois la valeur efficace nominale de la tension de ligne (U_{N}) et si toutes les valeurs efficaces de la tension de phase sont inférieures à 0,4 fois la valeur efficace nominale de la tension de phase (U_{fN}).
